(19) Europäisches Patentamt / European Patent Office / Office européen des brevets

(11) **EP 4 050 349 A1**

(12) **EUROPEAN PATENT APPLICATION**

(43) Date of publication:
**31.08.2022 Bulletin 2022/35**

(21) Application number: **21159202.7**

(22) Date of filing: **25.02.2021**

(51) International Patent Classification (IPC):
**G01R 19/20** (2006.01)      **H02H 3/33** (2006.01)

(52) Cooperative Patent Classification (CPC):
**H02H 3/33; G01R 19/20**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ABB Schweiz AG**
**5400 Baden (CH)**

(72) Inventors:
• **Butti, Agostino**
  **I-20151 Milano (IT)**
• **Curra, Antonio**
  **I-20081 Abbiategrasso (MI) (IT)**
• **Rigamonti, Francesco**
  **I-20013 Magenta (MI) (IT)**

(74) Representative: **De Bortoli, Eros et al**
**Zanoli & Giavarini S.p.A.**
**Via Melchiorre Gioia, 64**
**20125 Milano (IT)**

(54) **A RESIDUAL CURRENT DEVICE FOR LOW VOLTAGE ELECTRIC LINES**

(57)   An electronic device for a LV electric line including one or more conductors comprising a sensing stage adapted to detect the presence of residual currents in said electric line. Said sensing stage includes an innovative electronic arrangement to detect the presence of internal fault conditions in said electronic device.

FIG. 1

EP 4 050 349 A1

## Description

The present invention relates to a residual current device for low voltage electric lines.

As is known, residual current devices are electronic devices adapted to detect fault conditions (e.g. residual currents towards ground, over-voltages, over-currents, arcing phenomena, and the like) in an electric line.

Nowadays, residual current devices capable of detecting DC residual currents in an electric line are of particular industrial and commercial interest.

Unfortunately, the electronic devices of this type, which are currently available in the state of the art, have some critical aspects.

In general, these devices are not capable of carrying out diagnostic functionalities on the electronic stages intended for detecting residual currents in order to check the presence of internal faults, which may jeopardize residual current detection functionalities.

Additionally, these electronic devices implement relatively complex and cumbersome detection arrangements to sense DC residual currents and process the collected detection voltages. They are therefore relatively expensive to manufacture at industrial level. Moreover, they are often characterised by relatively high levels of power consumption, which may cause problems in several installations.

The main aim of the present invention is to provide an electronic device that allows overcoming or mitigating the above-mentioned criticalities of the known art.

Within this aim, a purpose of the present invention is to provide an electronic device capable of carrying out effective auto-diagnostic functionalities to check the presence of internal faults in the electronic stages dedicated to residual current detection.

A further purpose of the present invention is to provide an electronic device ensuring high performances in detecting DC residual currents and high reliability of intervention.

A further purpose of the present invention is to provide an electronic device having a high flexibility of use and capable of detecting also AC residual currents.

A further purpose of the present invention is to provide an electronic device, which has a simple structure characterised by a relatively small size.

A further purpose of the present invention is to provide an electronic device, which is relatively simple and cheap to be manufactured at industrial levels.

The above aim and purposes, as well as other purposes that will emerge clearly from the following description and attached drawings, are provided, according to the invention, by an electronic device according to the following claim 1 and the related dependent claims.

In a general definition, the electronic device, according to the invention, comprises a control unit including a sensing stage adapted to detect the presence of residual currents in an electric line.

According to some embodiments, the electronic device of the invention is intended to operate as an electronic protection device for low voltage electronic lines.

In this case, the electronic device comprises one or more pairs of electric contacts adapted to be electrically connected with corresponding conductors of the electric line. Conveniently, the electric contacts are mutually couplable or decouplable.

In addition to the above-mentioned sensing stage, the electronic device comprises also a trip unit and an operating mechanism operatively coupled to the electric contacts. The trip unit is adapted to actuate the operating mechanism in response to receiving a trip signal in input. The operating mechanism is adapted to mechanically interact with the electric contacts to carry out a tripping manoeuvre or an opening manoeuvre of the electronic device.

According to other embodiments of the invention, the electronic device is intended to operate as a residual current block operatively coupled to an external protection device (e.g. a circuit breaker) for low voltage electronic lines. In this case, the electronic device comprises a trip unit in addition to the sensing stage. This latter is operatively coupled (e.g. mechanically coupled) to an operating mechanism of the external protection device, which includes an operating mechanism operatively coupled to one or more pairs of electric contacts, which are in turn coupled to the line conductors of the electric line.

The above-mentioned trip unit is adapted to actuate (e.g. through a motion transmission mechanism) the operating mechanism of the external protection device in response to receiving a trip signal in input. Upon actuation by the trip unit, the operating mechanism mechanically interacts with the corresponding electric contacts to carry out a tripping manoeuvre or an opening manoeuvre of the external protection device.

According to some embodiments of the invention, the electronic device is intended to operate as residual current monitor. In this case, the electronic device merely comprises the above-mentioned sensing stage that is suitably configured to provide in output an alarm signal or a monitoring signal indicative of the detected residual current. Preferably, the electronic device of the invention comprises a power supply unit adapted to provide a power supply voltage to feed the internal electric or electronic components of the electronic device. The power supply unit is conveniently adapted to harvest electric power from the electric line.

According to the invention, the sensing stage comprises a detection module operatively coupled with the line conductors of an electric line. The detection module includes a magnetic core enchaining the line conductors of the electric line and a secondary winding arrangement coupled to the magnetic core and including a secondary winding wound around the magnetic core. The secondary winding arrangement is adapted to receive in input at least a driving voltage configured to make the magnetic core operate in a magnetic saturation condition.

The secondary winding arrangement is adapted to provide in output a detection voltage indicative of a winding current flowing along the secondary winding.

Preferably, the secondary winding arrangement comprises a resistive circuit electrically connected in series to the secondary winding to form a RL circuit in cooperation with the secondary winding.

Preferably, the secondary winding arrangement comprises a first input terminal electrically connected in series with the secondary winding and adapted to receive a first driving voltage, a second input terminal electrically connected in series with the resistive circuit and adapted to receive a second driving voltage and an output terminal electrically connected in series with a coupling node between the secondary winding and the resistive circuit and adapted to provide a detection voltage indicative of a current flowing along the secondary winding.

The sensing stage further comprises a comparator module adapted to receive in input the detection voltage from the secondary winding arrangement and provide in output an interrupt signal, when the winding current flowing along the secondary winding takes values not included in a predefined range.

Preferably, the comparator module is adapted to compare the detection voltage provided in output by the secondary winding arrangement with a first voltage threshold value and a second voltage threshold value higher than the first voltage threshold value. The comparator module is adapted to provide in output the interrupt signal when the detection voltage is lower than the first voltage threshold value or when the detection voltage is higher than the second voltage threshold value.

The sensing stage further comprises a first driving module adapted to feed the secondary winding arrangement with a first driving voltage switching between a high voltage level or a low voltage level and a second driving module adapted to feed the secondary winding arrangement with a second driving voltage having a constant voltage level.

The above-mentioned driving voltages are configured to make the magnetic core of the detection module operate respectively in a positive magnetic saturation condition or in a negative magnetic saturation condition.

The sensing stage further comprises a processing module adapted to command the first driving module to switch the first driving voltage between the high voltage level and the low voltage level in response to receiving an interrupt signal from the comparator module.

Preferably, the sensing stage further comprises a timer module and a clock module adapted to cooperate with the processing module to carry out time measuring tasks.

Preferably, the above-mentioned processing module, timer module and clock module are adapted to measure the first time interval and the second time interval of the first driving voltage, in response to receiving, by the processing module, the interrupt signal sent by the comparator module.

Preferably, the above-mentioned sensing stage further comprises an output module controlled by the processing module.

In the embodiments in which the electronic device of the invention is intended to operate as an electronic protection device or as a residual current block coupled to an external protection device, the processing module is adapted to command the output module to provide in output a trip signal, if the processing module determines that a tripping manoeuvre or opening manoeuvre is required.

In the embodiments in which the electronic device of the invention is intended to operate as a monitoring device, the processing module is adapted to command the output module to provide in output an alarm signal or a monitoring signal indicative of a detected residual current. According to the invention, the processing module is adapted to provide, based on the behaviour of the above-mentioned first driving voltage, a periodicity signal to check the presence of fault conditions in the sensing stage. The periodicity signal includes a sequence of count values, each of which is calculated as a sum between the measured first time interval and the measured second time interval.

Preferably, the processing module is adapted to process the periodicity signal according to a test procedure including the following steps:

- comparing the periodicity signal with a first time threshold value and a second time threshold value higher than the first time threshold value;
- if the periodicity signal is lower than the first time threshold value or higher than the second time threshold value, determining that fault conditions are present in the sensing stage.

Preferably, the test procedure comprises the following steps:

- if the periodicity signal is lower than the first time threshold value determining that the secondary winding is at least partially short-circuited or that a high residual current is present in the electric line;
- if the periodicity signal is higher than the second time threshold value determining that the secondary winding is at least partially interrupted or that one or more components of said sensing stage (20) are not correctly operating.

According to an aspect of the invention, the processing module is adapted to provide, based on the behaviour of said first driving voltage, a fault signal indicative of the presence of a residual current in the electric line.

The fault signal includes a sequence of count values, each of which is calculated as the difference between a measured first time interval, during which the first driving voltage takes the high voltage level, and a measured second time interval, during which the first driving voltage takes the low voltage level.

Preferably, the processing module is adapted to process the fault signal to determine whether a tripping manoeuvre or opening manoeuvre is required or to provide an alarm signal or a monitoring signal indicative of a detected residual current.

Preferably, the processing module is adapted to process the fault signal according to a determination procedure including the following steps:

- basing on the behaviour of the fault signal, calculating a maximum trip delay value for the electronic device;
- comparing the module of said fault signal with a current threshold value;
- if the module of said fault signal is higher than the current threshold value for a time interval longer than the maximum trip delay value, determining that a tripping manoeuvre or opening manoeuvre is required.

According to some embodiments of the invention, the sensing stage comprises a controller, preferably a microcontroller. At least the above-mentioned comparator module, processing module, first driving module, second driving module, but preferably also the above-mentioned output module, timer module and clock module, are formed by internal components of the controller.

Preferably, the controller is fed by a supply voltage having a voltage level (e.g. about 3.3V) comparable to the high voltage level or the low voltage level of the first driving voltage. In particular, the controller is fed by a supply voltage having a voltage level VS given by the following relation:

$$VS <= V_H - V_L$$

wherein $V_H$ and $V_L$ are respectively the high voltage level and the low voltage level of the first driving voltage.

According to some embodiments of the invention, the electronic device comprises a further sensing stage adapted to sense the presence of fault conditions in the electric line regardless of the availability of a power supply voltage to feed the internal electric or electronic components of the electronic device.

Further characteristics and advantages of the invention will become apparent from the detailed description of exemplary embodiments of the electronic device, which is illustrated only by way of non-limitative examples in the accompanying drawings, wherein:

- Figure 1 is a block diagram of a LV electric line to which an electronic device, according to the invention, is operatively associated;
- Figure 2, 2A, 2B, 3 schematically show some exemplary embodiments of the electronic device, according to the invention;

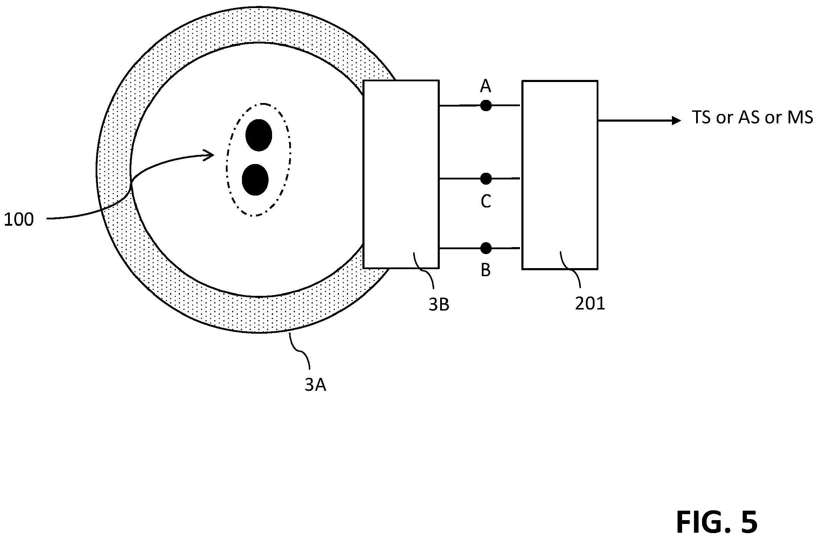

- Figures 4-5 schematically shows different views of a sensing stage included in the electronic device, according to some embodiments of the invention;
- Figures 6-10 schematically show the operation of the sensing stage shown in figures 4-5. With reference to the cited figures, the present invention relates to an electronic device 1 for low-voltage electric lines.

For the purposes of the present application, the term "low voltage" (LV) relates to operating voltages lower than 1 kV AC and 1.5 kV DC.

In operation, the electronic device 1 is operatively coupled to a low-voltage electric line 100, which, in general, comprises one or more phase conductors P and, preferably, a neutral conductor N.

In the following, the electronic device 1 will be described as coupled to an electric line having a sole phase conductor P and a neutral conductor N for the sake of simplicity. However, this choice is not intended to limit the scope of the invention. As the skilled person will certainly understand, the electric line 100 may be arranged differently, for example according to a 3P+N configuration or a 2P+N configuration.

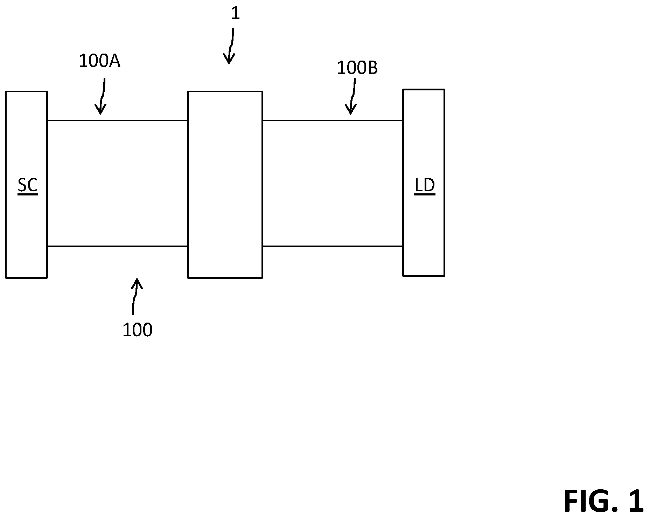

The electric line 100 is intended to connect electrically an electric power source SC and an electric load LD, which may be of any type (figure 1).

In general, the electronic device 1 is a RCD (Residual Current Device), i.e. an electronic device capable of detecting residual currents in an electric line. In particular, the electronic device 1 is capable of detecting DC residual currents (either smooth or pulsating) and AC residual currents (in particular AC currents having frequencies lower than 1,5 kHz).

The electronic device 1 is particularly suitable to operate as an electronic protection device, in particular as a RCCB (Residual Current Circuit Breaker) device of B-Type.

However, the electronic device 1 may also operate as a RCBO (Residual Current circuit Breaker with Overcurrent protection) device, a RCM (Residual Current Monitor), a residual current block, or the like.

Figures 1-2 show an embodiment of the invention, in which the electronic device 1 is configured to operate as an electronic protection device, e.g. as a RCCB of B-type.

In this case, in operation, the electronic device 1 allows or interrupts a line current IL flowing between the electric power source SC and the electric load LD, more precisely between upstream portions 100A and downstream portions 100B of the electric line 100, which are electrically connected with the electric power source SC and the electric load LD, respectively. According to some configurations (typically dedicated to the North American market), the electronic device 1 can operate in three different operative states, namely a closed state, a tripped state and an open state.

According to other configurations (typically dedicated to the European or other international markets), the electronic device 1 can operate in two different operative states only, namely a closed state and an open state.

When it operates in a closed state, the electronic device 1 allows the line current IL to flow along the electric line 100 between the line portions 100A, 100B.

When it is in a tripped state or open state, the electronic device 1 interrupts the line current IL, thereby electrically disconnecting the line portions 100A, 100B.

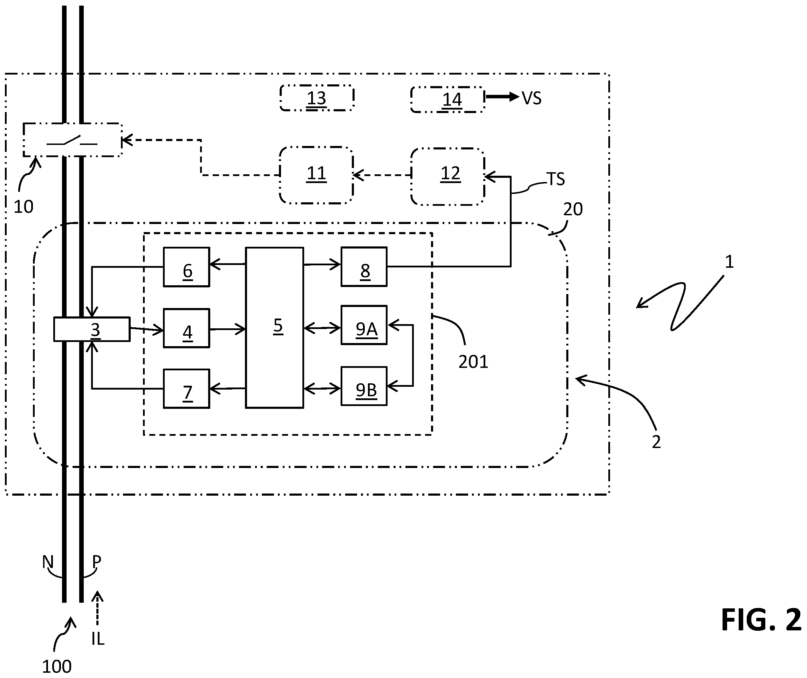

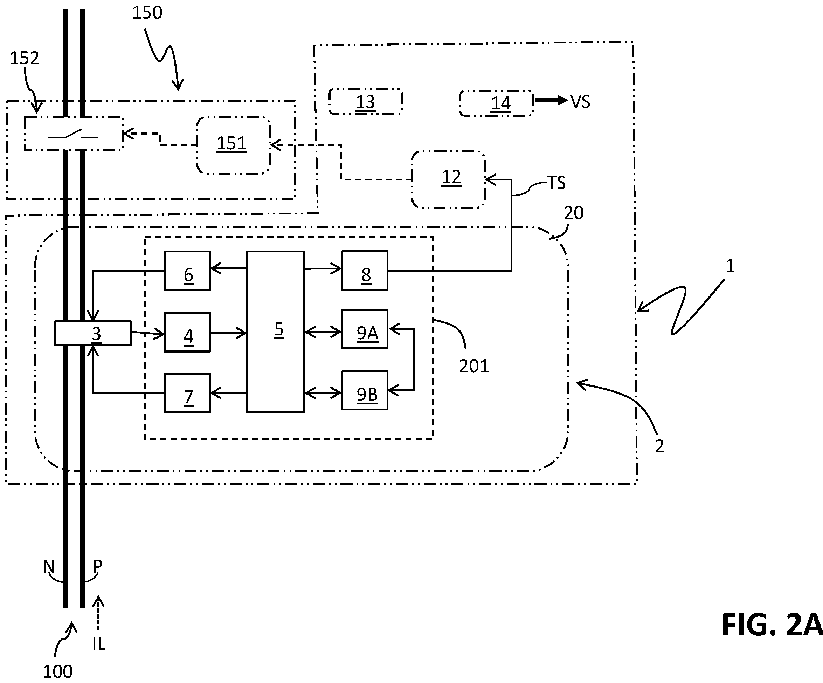

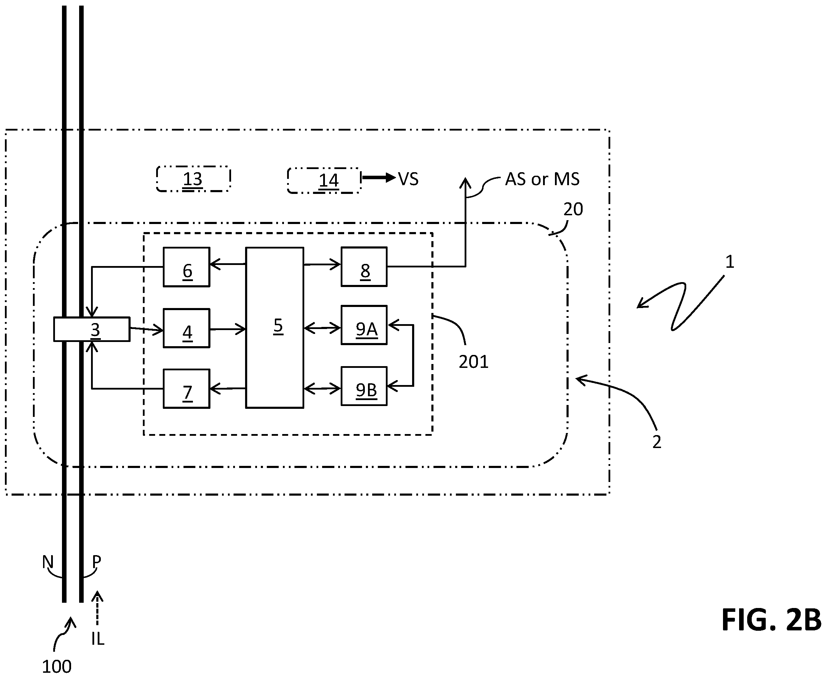

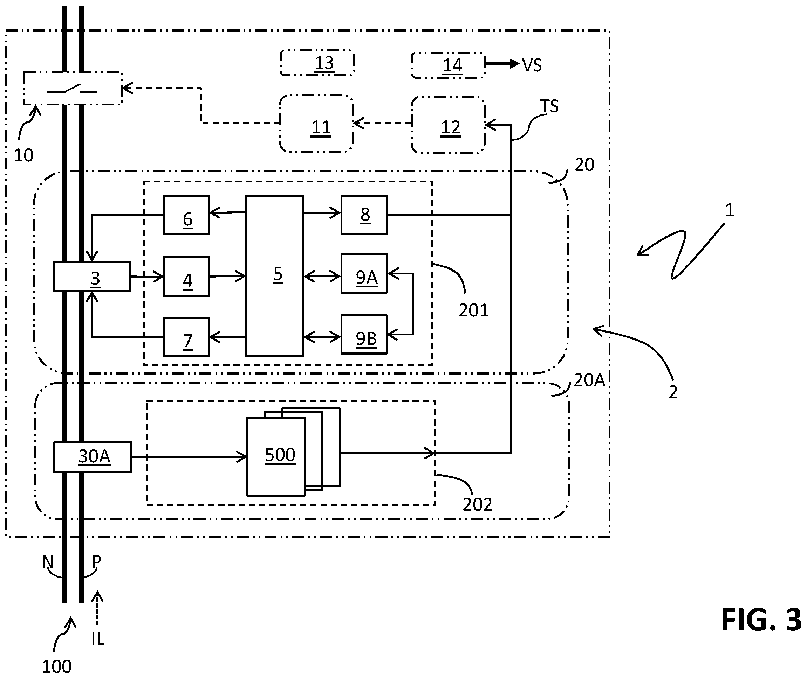

The electronic device 1 comprises one or more pairs of electric contacts 10 including a mobile contact and a fixed contact (figures 2 and 3).

Each pair of electric contacts 10 is intended to be electrically connected to a corresponding conductor of the electric line 100.

The electric contacts 10 can be mutually coupled or separated.

When the electric contacts 10 are mutually coupled, the electronic device 1 is in a closed state whereas, when the electric contacts 10 are decoupled, the device 1 is in a tripped state or an open state (depending on the configuration of the electronic device).

When the electric contacts 10 pass from a coupled condition to a decoupled condition, the electronic device 1 carries out a tripping manoeuvre or opening manoeuvre.

The electric contacts 10 and their electrical connection with the corresponding conductors of the electric line 100 may be realized in known manners here not described in more details for the sake of brevity.

The electronic device 1 comprises an operating mechanism 11 operatively coupled to the electric contacts 10 (in particular with the mobile contacts thereof) and mechanically interacting with these latter.

The electronic device 1 further comprises a trip unit 12 adapted to mechanically actuate the operating mechanism 11.

In operation, upon receiving a suitable trip signal TS, the trip unit 12 actuates the operating mechanism 11 to decouple the electric contacts 10, thereby carrying out a tripping manoeuvre or opening manoeuvre of the electronic device.

Preferably, the trip unit 12 comprises an electromagnetic actuator.

The electronic device 1 conveniently comprises other mechanical components, e.g. a handle 13 operatively coupled with the operating mechanism 11 and mechanically interacting with this latter.

The handle 13 is movable (preferably around a suitable rotation axis) between two or three operating positions (depending on the configuration of the electronic device).

The handle 13 may be actuated by the operating mechanism 11, by a user or by external equipment in order to actuate the operating mechanism 11 and couple or decouple or maintain decoupled (depending on the configuration of the electronic device) the electric contacts 10. Preferably, the electronic device 1 comprises a power supply unit 14 adapted to provide a power supply voltage VS to feed the internal electric or electronic components of said electronic device by harvesting electric power from the electric line 100.

In general, the operating mechanism 11, the trip unit 12, the handle 13 and the power supply unit 14 of the electronic device may be realized and operatively coupled in known manners here not described in more details for the sake of brevity.

Figure 2A shows an embodiment of the invention, in which the electronic device 1 is configured to operate as a residual current block operatively coupled to an external protection device 150 (e.g. a MCB - Miniature Circuit Breaker), which may be of known type.

The external protection device 150 comprises an operating mechanism 151 operatively coupled to one or more pairs of electric contacts 152.

Each pair of electric contacts 152 includes a mobile contact and a fixed contact and is intended to be electrically connected to a corresponding conductor of the electric line 100.

The electric contacts 152 can be mutually coupled or separated.

When the electric contacts 152 are mutually coupled, the external protection device 150 is in a closed state whereas, when the electric contacts 152 are decoupled, the protection device 150 is in a tripped state or an open state (depending on the configuration of the electronic device). When the electric contacts 152 pass from a coupled condition to a decoupled condition, the external protection device 150 carries out a tripping manoeuvre or opening manoeuvre.

The operating mechanism 150 is operatively coupled to the electric contacts 152 (in particular with the mobile contacts thereof) and mechanically interact with these latter to carry out a manoeuvre of the external protection device 150.

This embodiment of the invention differs from the embodiment shown in figures 1-2 in that the electronic device 1 does not include electric contacts or mechanisms interacting with said electric contacts. In this case, the basic purpose of the electronic device 1 is to actuate the operating mechanism 151 of the protection device 150.

The electronic device 1 thus merely includes a trip unit 12 (possibly of known type), which is operatively coupled to the operating mechanism 151 and to the one or more pairs of electric contacts 152 arranged in the above-mentioned external protection device.

In operation, the trip unit 12 of the electronic device 1 is capable of actuating (e.g. through a motion transmission mechanism) the operating mechanism 151 of the external protection device 150 in response to receiving a trip signal TS in input. Upon actuation by the trip unit 12, the operating mechanism 151 of the protection device 150 mechanically interacts with the electric contacts 152 to carry out a tripping manoeuvre or an opening manoeuvre of said external protection device.

Figure 2B shows an embodiment of the invention, in which the electronic device 1 is configured to operate as a RCM.

According to this embodiment of the invention, differently from the embodiments shown in figures 1-2 and 2A, the electronic device 1 does not include electric contacts coupled with the conductors of the electric line, mechanisms interacting with said electric contacts or trip units. In this case, the basic purpose of the electronic device 1 is to provide in output an alarm signal AS or a monitoring signal MS indicative of a detected residual current.

According to the invention, the electronic device comprises a control unit 2 aimed at controlling the general operation of said electronic device.

Conveniently, the control unit 2 comprises one or more sensing stages to detect possible fault conditions in the electric line.

Fault conditions may include, for example, residual currents, arc faults, over-currents, over-voltages, internal faults in the electronic device, and so on.

According to some embodiments of the invention, each sensing stage includes a dedicated controller (preferably a microcontroller), which conveniently includes data processing resources of digital type (e.g. a CPU) capable of executing stored software instructions, peripheral components and I/O ports.

In some cases, however, multiple sensing stages of the control unit 2 may share a common controller to operate.

Obviously, the control unit 2 may include further electronic stages, modules, components, controllers and the like. These additional elements (not shown) may be of known type and they are not described in the following for the sake of brevity.

An important feature of the electronic protection, according to the invention, consists in that the control unit 2 comprises an innovative sensing stage 20 adapted to detect the presence of residual currents in the electric line 100.

According to some embodiments of the invention (figures 2, 2A, 3), the sensing stage 20 is adapted to provide in output a trip signal TS, when a tripping manoeuvre or opening manoeuvre is required.

According to other embodiments of the invention (figure 2B), the sensing stage 20 is adapted to provide in output an alarm signal AS or a monitoring signal MS indicative of a detected residual current present in the electric line 100.

The sensing stage 20 comprises a detection module 3, which, in operation, is operatively coupled with the line conductors N, P of the electric line 100.

The detection module 3 comprises a magnetic core 3A coupled to the line conductors N, P of the electric line 100 in such a way to enchain said conductors.

Preferably, the magnetic core 3A is shaped as a toroid so that the conductors N, P of the electric line 100 can be arranged to pass through it.

Preferably, the magnetic core 3A is made of a magnetic material, for example a nanocrystalline material.

Preferably, such a magnetic material has not high magnetic permeability values (e.g. a relative magnetic permeability $m_r \approx 60000$) in comparison to RCDs of the state of the art.

Also, the magnetic core 3A is selected with a relatively small relative size in comparison with magnetic elements employed for the same purposes.

Both these solutions allow reducing the overall size of the sensing stage 20. In addition, they allow reducing the equivalent inductance of the magnetic core 3A and, therefore, the level of magnetization current necessary for magnetizing it. Obviously, this allows reducing the power consumption of the sensing stage 20.

The detection module 3 comprises a secondary winding arrangement 3B coupled to the magnetic core 3A and including a secondary winding 31 wound around said magnetic core. It is evident that the assembly including the above-mentioned magnetic core 3A and the secondary winding 31 forms a current transformer, the primary winding of which is formed by the conductors of the electric line 100 enchained with the magnetic core 3A.

The secondary winding arrangement 3B is adapted to receive in input at least a driving voltage $V_A$, $V_B$ configured to make the magnetic core 3A to operate in a magnetic saturation condition and it is adapted to provide in output a detection voltage $V_C$ indicative of a current flowing along the secondary winding 31.

Preferably, the secondary winding arrangement 3B comprises a first input terminal A adapted to receive a first driving voltage $V_A$, a second input terminal B adapted to receive a second driving voltage $V_B$ and an output terminal C adapted to provide a detection voltage $V_C$ indicative of a current Iw flowing along the secondary winding 31.

Preferably, the secondary winding arrangement 3B comprises a resistive circuit 32 (preferably formed by a resistor) electrically connected in series to the secondary winding 31 to form a RL circuit in cooperation with said secondary winding.

Preferably, the first input terminal A is electrically connected in series with the secondary winding 31, the second input terminal B is electrically connected in series with the resistive circuit 32 and the output terminal C is electrically connected in series with an electric node coupling the secondary winding 31 and the resistive circuit 32.

Since the secondary winding 31 and the resistive circuit 32 forms a RL circuit, the detection voltage $V_c$ at the output terminal C is given by the following relation:

$$V_C = RI_W + V_B$$

where R is the equivalent resistance of the resistive circuit 32, Iw is the current flowing along the secondary winding 31 (and therefore along the resistive circuit 32) and $V_A$, $V_B$ are the driving voltages provided at the above-mentioned input terminals A, B.

The detection voltage $V_C$ at the output terminal C is thus indicative of the winding current Iw flowing along the secondary winding 31.

Preferably, the secondary winding arrangement 3B comprises a single secondary winding 31. This solution simplifies the circuit integration of the secondary winding arrangement 3B with the remaining operating modules of the sensing stage 20.

Preferably, the secondary winding arrangement 3B comprises a first buffer circuit 33 electrically connected in series between the first input terminal A and the secondary winding 31 and a second buffer circuit 34 electrically connected in series between the second input terminal B and the resistive circuit 32. Conveniently, the first and second buffer circuits 33, 34 may comprise suitable amplifiers to amplify the winding current Iw flowing along the secondary winding 31 and the resistive circuit 32.

The sensing stage 20 comprises a comparator module 4 adapted to receive in input the detection voltage $V_C$ from the secondary winding arrangement 32 and provide in output an interrupt signal INT, when the winding current Iw flowing along the secondary winding 31 has values not included in a predefined range.

In general, the interrupt signal INT is an asynchronous signal provided by the comparator module 4 to a specific processing module (the processing module 5) in order to communicate the occurrence of an event (i.e. the circumstance that the winding current Iw has values not included in a predefined range).

As it will better emerge from the following, the above-mentioned processing module carries out a specific task in response to receiving said interrupt signal.

Preferably, the comparator module 4 is adapted to compare the detection voltage $V_C$ with a first voltage threshold value $V_{TH1}$ and with a second voltage threshold value $V_{TH2}$, which is higher than said first voltage threshold value. The comparator module 4 is adapted to provide in output the interrupt signal INT when the detection voltage $V_C$ is lower than the first voltage threshold value $V_{TH1}$ or when the detection voltage $V_C$ is higher than the second voltage threshold value $V_{TH2}$.

The first and second voltage threshold values $V_{TH1}$, $V_{TH2}$ are predefined voltage values corresponding to the current values that the winding current Iw has to reach in order to bring the magnetic core 3A in a saturation condition. Conveniently, the above-mentioned voltage threshold values $V_{TH1}$, $V_{TH2}$ are defined depending on the magnetic properties of the magnetic core 3A.

Preferably, the secondary winding arrangement 3B comprises a capacitive circuit 35 electrically connected in parallel to the secondary winding 31 and a low-pass filter 36 electrically connected between the output terminal C and a ground terminal.

This solution allows reducing the high-frequency noise in input to the comparator module 4 and the other modules of the sensing stage 20, which remarkably improves the operation of this latter.

The sensing stage 20 comprises a first driving module 6 adapted to feed the secondary winding arrangement 32 with a first driving voltage $V_A$, conveniently at the first input terminal A. The first driving voltage $V_A$ has a pulsed waveform. Namely, the first driving voltage $V_A$ can switch to a high voltage level $V_H$ or to a low voltage level $V_L$.

Preferably, the high voltage level is $V_H \approx 3.3$ V while the low voltage level is $V_L \approx 0$ V. In this way, the driving voltage $V_A$ is suitable for being processed in a digital manner.

The sensing stage 20 further comprises a second driving module 7 adapted to feed the secondary winding arrangement 32 with a second driving voltage $V_B$, conveniently at the second input terminal B.

The second driving voltage $V_B$ has a constant value configured in such a way to provide a positive voltage bias to the RL circuit formed by the secondary winding 31 and the resistive circuit 32. As an example, the second driving voltage $V_B$ has a constant value given by the following relation:

$$V_B = (V_H + V_L)/2$$

where $V_H$, $V_L$ are the higher and lower voltage level of the first driving voltage $V_A$. Obviously, if the high voltage level is $V_H \approx 3.3$ V and the low voltage level is $V_L \approx 0$ V, the second driving voltage $V_B$ has a constant value $V_B = V_H/2$. Such a constant value may be suitably calibrated in order to compensate measurement offsets.

The driving voltages $V_A$, $V_B$ are conveniently configured in such a way to force the magnetic core 3A of the detection module 3 to reach a saturation condition, namely a positive saturation condition or a negative saturation condition, when they are applied at the input terminals A, B. For the sake of clarity, it is specified that the term "positive saturation condition" refers to a saturation condition of the magnetic core 3A, in which the winding current Iw has a conventionally positive sign, whereas the term "negative saturation condition" refers to a saturation condition of the magnetic core 3A, in which the winding current Iw has a conventionally negative sign.

The sensing stage 20 comprises a processing module 5 adapted to control the first driving module 6 and the second driving module 7.

The processing module 5 conveniently comprises data processing resources to carry out signal processing functionalities and control functionalities.

According to the invention, the processing module 5 is adapted to receive the interrupt signals INT provided by the comparator module 4 and carry out a specific task in response to receiving said interrupt signals. Said specific task consists in commanding (through suitable control signals) the first driving module 6 to switch the first driving voltage $V_A$ between the above-mentioned high voltage level $V_H$ and low voltage level $V_L$ in response to receiving an interrupt signal INT from the comparator module 4.

In practice, the processing module 5 is adapted to command the first driving module 6 to switch the voltage level of the first driving voltage $V_A$ provided to the secondary winding arrangement 3B to drive the magnetic core 3A in a positive or negative saturation condition, each time the comparator module 4 signals the occurrence of an event through an interrupt signal INT. Such an event consists in that the winding current Iw flowing along the secondary winding 31 takes values not included in a predefined range.

The voltage level transition carried out by the first driving module 6 depends on the voltage level taken by the first driving voltage $V_A$ when the interrupt signal INT is received by the processing module 5.

If the first driving module 6 is providing a first driving voltage $V_A$ having a high voltage level $V_H$, the processing module 5 commands the first driving module 6 to switch said driving voltage to a low voltage level $V_L$ in response to receiving the above-mentioned interrupt signal INT. On the other hand, if the first driving module 6 is providing a first driving voltage $V_A$ having a low voltage level $V_L$, the processing module 5 commands the first driving module 6 to switch said driving voltage to a high voltage level $V_H$ in response to receiving the above-mentioned interrupt signal INT.

As mentioned above, also the second driving module 7 is controlled by the processing module 5. Conveniently, the processing module 5 is adapted to command (through suitable control signals) the second driving module 7 to provide a second driving voltage $V_B$ having a constant level to the secondary winding arrangement 3B to bias in a suitable manner the RL circuit formed by the secondary winding 31 and the resistive circuit 32.

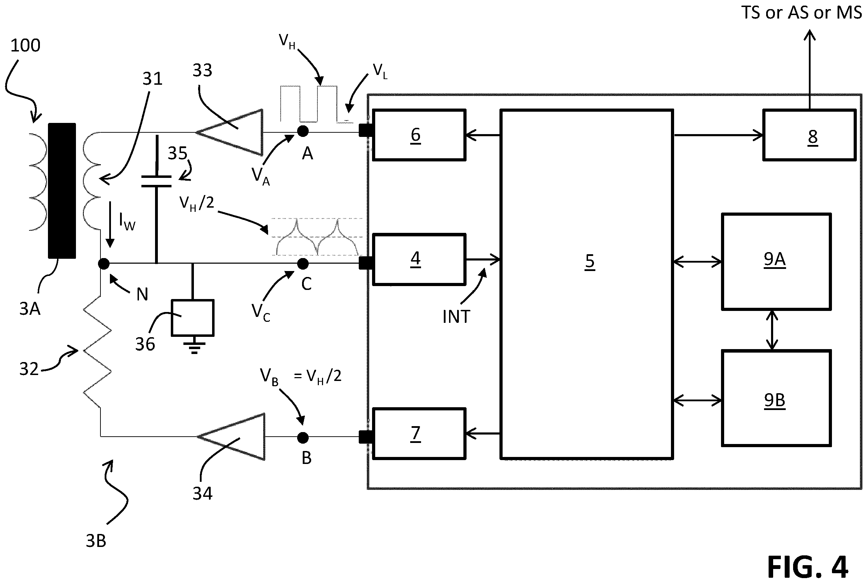

The general operation of the assembly formed by the secondary winding arrangement 3A, the comparator module 4, the processing module 5 and the driving modules 6,7 is shown in figure 4.

The first driving module 6 is initially supposed to feed the secondary driving arrangement 3B with a first driving voltage $V_A$ at high voltage level $V_H$.

In this case, the overall driving voltage applied to the secondary winding arrangement 3B at the input terminals A, B is given by the following relation: $VA-V_B = V_H - V_H/2 = V_H/2$.

The magnetic core 3A is thus forced to switch to a positive saturation condition.

The winding current Iw (voltage signal $V_C$) increases with an exponential trend having a given time constant $t = L/R$, where L is the equivalent inductance of the magnetic core 3A and where R is the equivalent resistance of the resistive circuit 32.

When the winding current Iw reaches a higher threshold value (which corresponds to the above-mentioned second voltage threshold value $V_{TH2}$), the magnetic core 3A reaches a positive saturation condition. The comparator module 4 provides in output an interrupt signal INT. Upon receiving said interrupt signal, the processing module 5 commands the first driving module 6 to switch the first driving voltage $V_A$ to a low voltage level $V_L$.

In this case, the overall driving voltage applied to the secondary winding arrangement 3B at the input terminals A, B is given by the following relation: $VA-V_B = 0 - V_H/2 = -V_H/2$.

The magnetic core 3A is thus forced to switch to a negative saturation condition and the winding current Iw (voltage signal Vc) decreases with a reversed exponential trend. When the winding current Iw reaches a lower threshold value (which corresponds to the above-mentioned first voltage threshold value $V_{TH1}$), the magnetic core 3A reaches a negative saturation condition. The comparator module 4 provides in output a new interrupt signal INT. Upon receiving such a new interrupt signal, the processing module 5 commands the first driving module 6 to switch the first driving voltage $V_A$ again to a high voltage level $V_H$.

In operation, the winding current Iw is therefore subject to subsequent oscillations in response to corresponding level transitions of the first driving voltage $V_A$ applied to the secondary winding 31. At each trend inversion, the winding current Iw is subject to an increase or decrease until the magnetic core 3A reaches a positive or negative saturation condition.

Such a solution provides outstanding levels of accuracy in detecting possible residual currents in the electric line 100. The magnetic flux flowing along the magnetic core 3A is suitably reversed as soon as such a magnetic core reaches a saturation condition. As a result, the behavior of magnetic core 3A is substantially immune to hysteresis effects of the magnetic flux and to possible temperature variations.

The assembly formed by the secondary winding arrangement 3A, the comparator module 4, the processing module 5 and the driving modules 6, 7 therefore provides a closed-loop control of the operating conditions of the magnetic core 3A, which allows increasing the reliability in detecting possible residual currents in the electric line 100.

According to preferred embodiments of the invention, the sensing stage 20 comprises a timer module 9A and a clock module 9B adapted to cooperate with the processing module 5 to carry out time measuring tasks.

As it will better emerge from the following, carrying out such time measuring tasks is necessary for acquiring information about the presence of possible residual currents or faults basing on the behaviour of the first driving voltage $V_A$ provided by the first driving module 6. According to an aspect of the invention, the sensing stage 20 comprises an output module 8 controlled by the processing module 5.

According to some embodiments of the invention (figures 2, 2A, 3), the processing module 5 is adapted to command (through suitable control signals) the output module 8 to provide in output a trip signal TS for the trip unit 12 of the electronic device, if it is determined that a tripping manoeuvre or opening manoeuvre is required.

When the electronic device 1 is configured to operate as a RCM (figure 2B), the processing module 5 is adapted to command the output module 8 an alarm signal AS or a monitoring signal MS indicative of the detected residual current.

In principle, the above-mentioned modules 3, 4, 5, 6, 7, 8, 9A, 9B of the sensing stage 20 may be industrially implemented in an analog and/or digital manner.

If they are implemented in analog manner, they will comprise electronic circuits suitably arranged to perform their functionalities. Said electronic circuits may form separated circuit units or may be at least partially integrated in one or more circuit units.

If they are implemented in a digital manner, they will be part of a digital controller capable of executing software instructions stored in a medium to perform their functionalities.

In general, the above-mentioned detection module 3 is implemented in an analog manner by arranging suitable electronic circuits on a PCB support. This solution remarkably simplifies the integration of the secondary winding 31 in the secondary winding arrangement 3B and the consequent coupling of this latter with the magnetic core 3A.

According to preferred embodiments of the invention, the above-mentioned modules 4, 5, 6, 7, 8, 9A, 9B of the sensing stage 20 are implemented digitally. In this case, the sensing stage 20 conveniently comprises a digital controller 201 (for example a microcontroller), which is preferably arranged on the same PCB support of the detection module 3.

Conveniently, at least the comparator module 4, the processing module 5, the first driving module 6, the second driving module 7 (and, possibly, also the output module 8, the timer module 9A and the clock module 9B) of the sensing stage 20 are formed by internal components of the controller 201.

In particular, the comparator module 4, the first driving module 6, the second driving module 7 and the output module 8 may be suitable peripheral components of the controller 201. These components are operatively coupled to corresponding input or output ports of the controller 201, at which the above-mentioned first driving voltage $V_A$, second driving voltage $V_B$, detection voltage Vc, trip signal TS are provided in output or received in input.

The processing module 5 may be the CPU (Central Processing Unit) of the controller 201 while the timer module 9A and the clock module 9B are formed by the standard internal timer component and clock component of the controller 201.

In the following, the present invention will be described in further details with reference to the above-illustrated preferred embodiments for the sake of simplicity.

These solutions, in fact, provide relevant advantages in terms of size and cost reduction and in terms of power consumption reduction.

Additionally, they provide remarkable benefits in terms of easiness of operation and flexibility of use. As a matter of fact, the operation of the above-mentioned modules 4, 6, 7, 8, 9A, 9B (peripheral components or standard internal components of the controller 201) may be controlled by the processing module 5 according to standardized control logics. Possible additional functionalities may be easily implemented by suitably programming the software instructions (firmware) processed by the processing module 5 or by suitably exploiting further internal or peripheral components of the controller 201 (e.g. for signaling purposes). According to other embodiments of the invention, however, the sensing stage 20 may be arranged differently.

As an example, at least one of the above-mentioned modules 4, 6, 7 may be implemented in an analog manner by arranging suitable electronic circuits on a PCB support.

As a further example, the sensing stage 20 may comprise multiple controllers mutually cooperating one to another and each module 4, 5, 6, 7, 8, 9A 9B of the sensing stage 20 may be implemented by one or more internal components of said controllers.

A peculiar aspect of the invention consists in that the processing module 5 is capable of acquiring information about the presence of fault conditions in the sensing stage 20 by suitably analysing the behaviour of the first driving voltage $V_A$ provided by the first driving module 6. In particular, the processing module 5 is capable of calculating a periodicity signal PS indicative of the presence of fault conditions in the sensing stage 20.

The periodicity signal PS conveniently includes a sequence of count values, each of which is calculated as the sum between a measured first time interval $T_H$, at which the first driving voltage $V_A$ takes the high voltage level $V_H$, and a measured second time interval $T_L$, at which the first driving voltage $V_A$ takes the low voltage level $V_L$.

In practice, each count value PS($k$) is calculated at a generic instant k according to the following relation:

$$PS(k) = T_H(k) + T_L(k) = T(k)$$

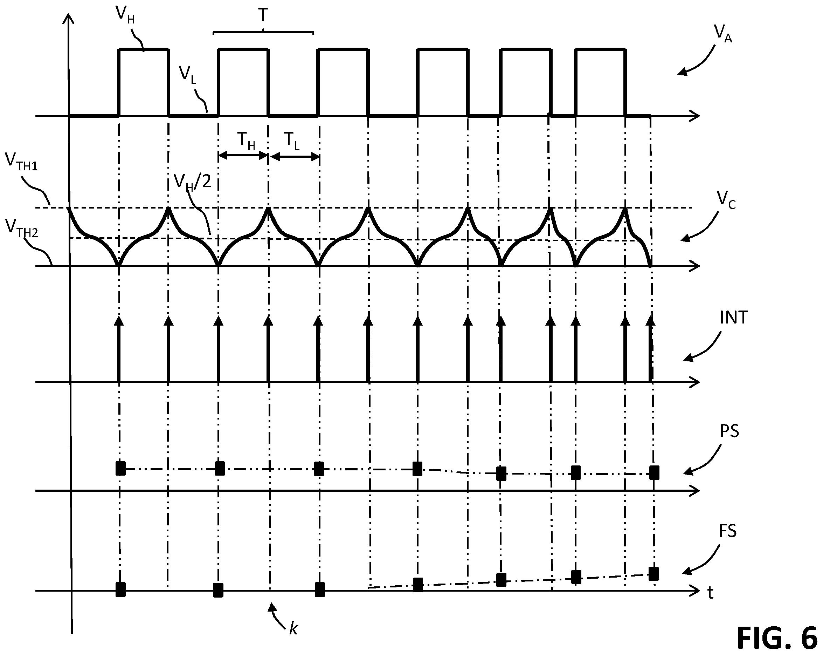

where $T_H(k)$, $T_L(k)$ are the time intervals $T_H$, $T_L$ as measured at the generic instant $k$ (figure 6) and T($k$) is the variable period of the first driving voltage $V_A$ as calculated at the generic instant $k$.

This further capability of the processing module 5 finds its technical ground on the circumstance that the period T= $T_H$+$T_L$ of the first driving voltage $V_A$ is not constant but it varies depending on the residual current present in the electric line 100.

The period T= $T_H+T_L$ of the of the first driving voltage $V_A$ remains substantially constant when a relatively small residual current flows along the electric line 100 and it becomes shorter when a relatively high residual current flows along the electric line 100.

Additionally, the period T= $T_H+T_L$ of the first driving voltage $V_A$ may vary depending on the operating conditions of the secondary winding 31. For example, it becomes shorter when multiple wires of the secondary winding 31 are short-circuited (this event causes a decrease of the equivalent inductance L of the magnetic core) and it becomes longer (or infinite) when one or more wires of the secondary winding 31 are at least partially interrupted (this event causes a change in the equivalent impedance of the secondary winding 31).

The processing module 5, timer module 9A and clock module 9B are preferably adapted to measure the above-mentioned time intervals $T_H$ and $T_L$, at each instant in which the processing module 5 receives the interrupt signal INT sent by the comparator module 4. As a consequence, also each count value PS($k$) of the periodicity signal PS is conveniently calculated at each instant k in which the measurement of two consecutive time intervals $T_H$, $T_L$ is completed (i.e. at each instant k in which two consecutive interrupt signals INT are received by the processing module 5).

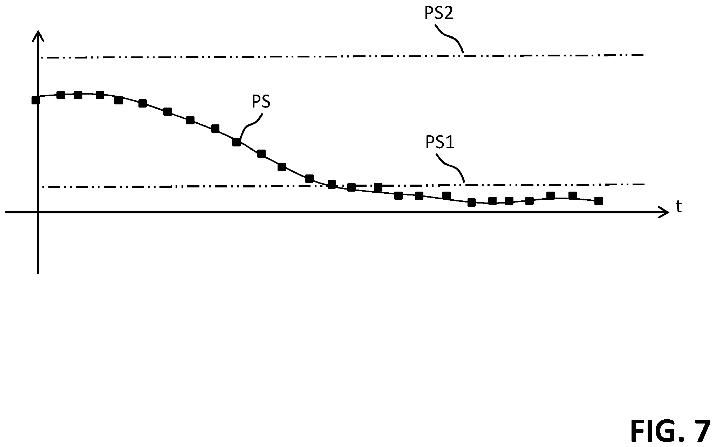

Conveniently, the processing module 5 is capable of processing the periodicity signal PS so calculated in order to determine whether fault conditions are present in the sensing stage 20. Preferably, the processing module 5 carries out a test procedure to determine whether fault conditions are present in the second winding arrangement 3B (figures 7-8).

Preferably, the above-mentioned test procedure includes a step, in which the processing module compares the periodicity signal PS with a first time threshold value PS 1 and with a second time threshold value PS2, which is higher than the first time threshold value PS1.

The first and second threshold value PS1, PS2 are indicative respectively of a minimum and maximum time value acceptable for the variable period T($k$) of the first driving voltage $V_A$.

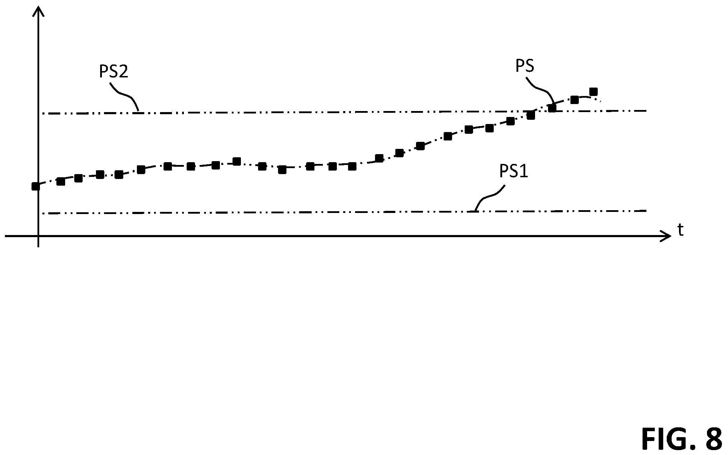

If the periodicity signal PS is lower than the first time threshold value PS 1 (figure 7) or higher than the second time threshold value PS2 (figure 8), the processing module 5 determines that fault conditions are present in the secondary winding arrangement 3B.

Preferably, the processing module 5 commands the output module 8 to provide in output a trip signal TS for the trip unit 12 or to provide in output an alarm signal AS.

Preferably, the processing module 5 is configured to provide identification information about the fault conditions depending on the behaviour of the periodicity signal PS.

If the periodicity signal PS is lower than the first time threshold value PS1, the processing module 5 determines that the secondary winding 31 is at least partially short-circuited or that a high residual current circulates along the electric line 100. In both these cases, in fact, the characteristic time constant t of the RL circuit, which is formed by the resistive circuit 32 and the secondary winding 31, decreases due to a corresponding decrease of the inductance of the magnetic core 3A.

If the periodicity signal PS is higher than the second time threshold value PS2, the processing module 5 determines that the secondary winding 31 is interrupted. In this case, the magnetic core 3A does not switch between opposite saturation conditions anymore as the comparator module 4 does not provide interrupt signals INT in output. This event may occur when the secondary winding 31 is at least partially interrupted (i.e. it shows a high equivalent impedance) or when one or more components of the sensing stage 20 (e.g. the resistive circuit 32, the comparator module 4, the buffer circuits 33, 34) are not correctly operating for some reasons. This solution allows further improving the diagnostic functionalities provided by the processing module 5. In addition to detecting the presence of fault conditions, the processing module 5 is capable of providing information about the actual nature of these fault conditions, which may be important to address possible maintenance interventions.

Conveniently, the timer module 9A and the clock module 9B are configured to measure the time elapsed between one interrupt signal INT and the following one. If such a measured time exceeds a predefined threshold (as it occurs when the module 4 does not provide interrupt signals INT for any reasons), the timer module 9A provides an interrupt signal to the processing module 5 in substitution of the comparator module 4. In this way, the processing module can continue to operate and, possibly, provide an alarm signal AS.

Since the electronic device 1 is a RCD, the processing module 5 is obviously capable of acquiring information about the presence of a residual current in the electric line 100.

To this aim, the processing module 5 is preferably configured to analyse the behaviour of the first driving voltage $V_A$ provided by the first driving module 6.

Thus, the processing module is preferably configured to process the first driving voltage $V_A$ to provide a fault signal FS indicative of the presence of a residual current in said electric line.

According to preferred embodiments of the invention, the fault signal FS includes a sequence of count values, each of which is calculated as a difference between a measured first time interval $T_H$, at which the first driving voltage $V_A$ takes the high voltage level $V_H$, and a measured second time interval $T_L$, at which the first driving voltage $V_A$ takes the low voltage level $V_L$. This solution finds its technical ground on the circumstance that the first driving voltage VA is not an arbitrary signal.

The waveform of the first driving voltage $V_A$, and particularly the time distribution of the voltage transitions between the above-mentioned voltage levels $V_H$ and $V_L$, depends on the saturation conditions of the magnetic core 3A, which in turns depends on the behaviour of the winding current $I_W$ flowing along the secondary winding 31.

The presence of residual currents in the electric line 100 causes the rising of an offset component in the winding current $I_W$. This latter causes an increase or decrease of the time required by the magnetic core 3A to reach a saturation condition, thereby a corresponding variation of the time distribution of the voltage transitions of the first driving voltage $V_A$ and therefore of the waveform such a driving voltage (figure 6).

Therefore, it is possible to calculate a fault signal FS indicative of the presence of a residual current in the electric line 100 by suitably measuring the time intervals $T_H$ and $T_L$ required by the magnetic core 3A to reach a positive or a negative saturation condition.

Such a fault signal FS has a sequence of count values. Each count value FS($k$) is calculated at a generic instant $k$ according to the following relation:

$$FS(k) = T_H(k) - T_L(k)$$

where $T_H(k)$, $T_L(k)$ are the time intervals $T_H$, $T_L$ as measured at the generic instant $k$ (figure 6).

If there are no residual currents in the electric line 100, the fault signal FS will include a sequence of null count values, as the time intervals $T_H$, $T_L$ will have a same duration (figure 6 - left side).

If there is a residual current in the electric line 100, the fault signal FS will include a sequence of positive or negative count values, depending on the different duration of the time intervals $T_H$, $T_L$ (figure 6 - right side).

As mentioned above, the processing module 5, timer module 9A and clock module 9B are adapted to measure (in cooperation) the above-mentioned first time interval $T_H$ and second time interval $T_L$, at each instant in which the processing module 5 receives the interrupt signal INT sent by the comparator module 4. As a consequence, each count value FS($k$) of the fault signal FS is conveniently calculated at each instant k in which the measurement of two consecutive time intervals $T_H$, $T_L$ is completed (i.e. at each instant k in which two consecutive interrupt signals INT are received by the processing module 5).

As it is apparent, this solution remarkably simplifies the obtaining of the fault signal FS by the processing module 5.

Preferably, the processing module 5 is capable of processing the fault signal FS so calculated in order to determine whether a tripping manoeuvre or opening manoeuvre is required.

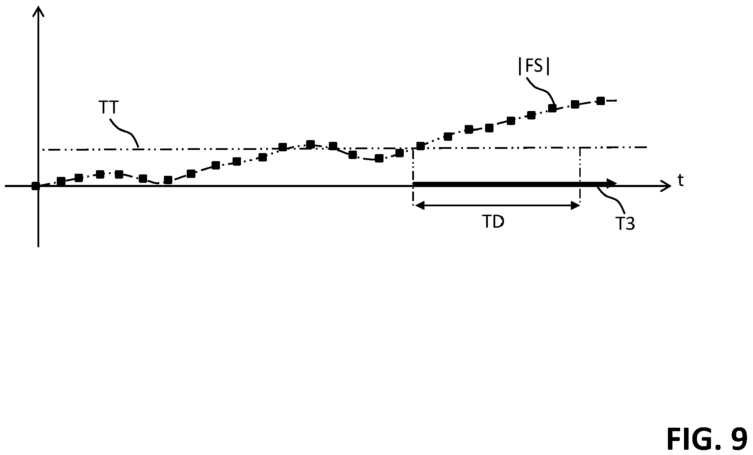

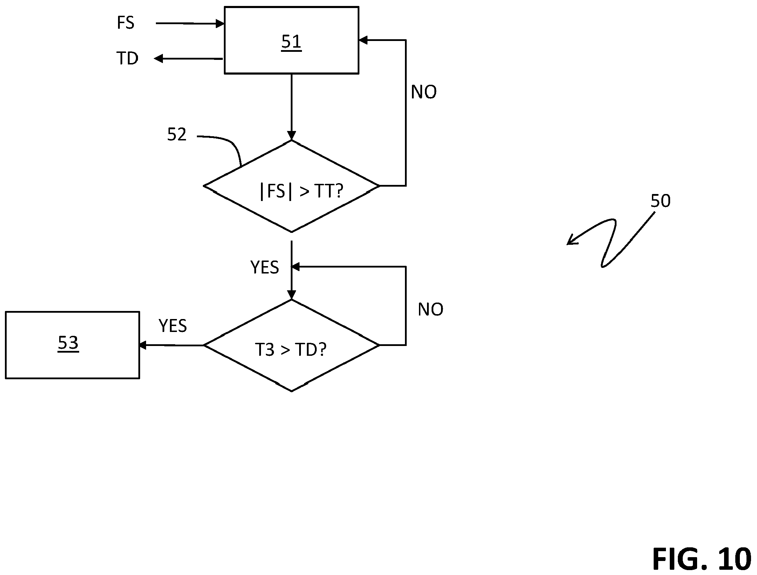

In particular, the processing module 5 carries out a determination procedure 50 (figures 9-10) to determine whether a tripping manoeuvre or opening manoeuvre is required.

The determination procedure 50 comprises a step 51, in which the processing module 5 calculates a maximum trip delay value TD for the electronic device basing on the behaviour of the fault signal FS.

Preferably, the processing modules 5 calculates an average value of the calculated count values of the fault signal FS (conveniently taking as a reference a selected period of time, e.g. 100 ms). Such an average value of the fault signal FS is obviously indicative of the average magnitude of the detected residual current during the selected period of time.

Preferably, basing on the standard regulations provided for the electronic device, the processing modules 5 calculates the maximum trip delay value TD acceptable for the electronic device, which corresponds to the calculated average residual current.

The determination procedure 50 comprises a step 52, in which the processing module 5 compares the module |FS| of the fault signal FS with a current threshold value TT. This latter is indicative of a maximum current value (in module) acceptable for a residual current flowing along the electric line 100. Conveniently, also the current threshold value TT may be determined basing on the standard regulations provided for the electronic device.

If the module |FS| of the fault signal FS is lower than the current threshold value TT, the determination procedure is terminated.

If the module |FS| of the fault signal FS is higher than the current threshold value TT, the processing module 5 checks whether the module of the fault signals FS exceeds the current threshold value TT for a time interval T3 longer than the above-mentioned maximum trip delay value TD.

When the above-mentioned condition is verified, the processing module 5 determines that a tripping manoeuvre or opening manoeuvre is required (step 53 of the determination procedure 50). In this case, the processing module 5 conveniently commands the output module 8 to provide in output a trip signal TS for the trip unit 12 of the electronic device.

Preferably, the processing module 5 is capable of processing the fault signal FS to obtain an alarm signal AS or a monitoring signal MS indicative of the detected residual current. The obtaining of these signals may be achieved by employing suitable algorithms of known type. From the description above, it is evident that the sensing stage 20 has to receive a suitable power supply VS from the power supply unit 14 in order to operate, for example in order to feed the controller 201 enclosing a number of modules of the sensing stage.

Preferably, the controller is fed by a supply voltage VS having a voltage level (about e.g. 3.3 V) comparable to the high voltage level $V_H$ or the low voltage level $V_L$ of the first driving voltage $V_A$. In particular, the controller is fed by a supply voltage having a voltage level VS given by the following relation:

$$VS <= V_H - V_L$$

wherein $V_H$ and $V_L$ are respectively the high voltage level and the low voltage level of the first driving voltage $V_A$.

This solution remarkably simplifies the integration of the controller 201 with the second winding arrangement 3B.

According to some embodiments of the invention (figure 3), the control unit 2 comprises a further sensing stage 20A adapted to sense the presence of fault conditions in the electric line 100 regardless of the availability of a power supply voltage VS to feed the internal electric or electronic components of the electronic device.

The additional sensing stage 20A is conveniently arranged in such a way to detect some possible fault conditions of the electric line 100 even if an auxiliary power supply is not available for some reasons.

Preferably, the additional sensing stage 20A is arranged in such a way to detect possible AC residual currents of the electric line 100.

Preferably, the additional sensing stage 20A comprises a further detection module 30A including a further magnetic core (not shown) adapted to enchain the line conductors of the electric line 100 and a further secondary winding arrangement (not shown) coupled to said magnetic core and including at least a further secondary winding wound around said magnetic core.

Preferably, the additional sensing stage 20A comprises one or more further processing modules 500 adapted to process detection signals indicative of said fault conditions provided by the detection module 30A and provide in output a trip signal TS when a tripping manoeuvre or opening manoeuvre is required.

Conveniently, the additional sensing stage 20A can be integrated with the sensing stage 20 on a same PCB support.

It has been found that the electronic device, according to the invention, fully achieves the intended aim and objects.

The electronic device 1 is equipped with an improved sensing stage 20 for residual current detection, which is capable of carrying out improved auto-diagnostic functionalities to check the presence of internal faults.

Such auto-diagnostic functionalities are automatically carried out during the operation of said sensing stage, without the need of being activated (e.g. through a so-called TEST button). Additionally, these auto-diagnostic functionalities allow collecting useful information about the possible nature of occurring fault, and are therefore quite effective in addressing possible maintenance interventions.

The electronic device 1, according to the invention, has a relatively simple and compact structure. The sensing stage 20 has a relatively small size as it includes a relatively small magnetic core and an assembly of highly integrated operating modules on suitably PCB supports.

The electronic device 1, according to the invention, provides reliable and efficient residual current detection functionalities. The sensing stage 20 is capable of detecting DC residual currents and also AC residual currents, in particular AC residual currents having frequency lower than the resonant frequency of the second winding arrangement 3B (about 1,5 kHz). The sensing stage 20 is capable of detecting residual currents with a wide dynamic range. The effects of possible non-linear behaviors of the magnetic core may be easily compensated by suitably programming the processing module 5 at firmware level.

The electronic device 1 is particularly suitable for operating as an electronic protection device or as a residual current block as the sensing stage 20 is capable of determining efficiently whether a tripping manoeuvre or opening manoeuvre of the electronic device is required either in case of presence of residual currents in the electric line 100 or in presence of internal fault conditions. However, the electronic device 1 has a remarkable flexibility in use and it may successfully operate as residual current monitor thanks to the outstanding residual current detection performances of the sensing stage 20.

Since the sensing stage 20 (in particular the controller 201) is fed with a relatively low voltage supply (in practice those normally used for microcontrollers), the electronic device 1 shows a low power consumption in operation.

The electronic device 1 has a simple structure, which is quite cheap to manufacture at industrial level.

## Claims

1. An electronic device (1) comprising a control unit (2) including a sensing stage (20) adapted to detect the presence of residual currents in a LV electric line (100) including one or more conductors (P, N) **characterised in that** said sensing stage (20) comprises:

    - a detection module (3) operatively couplable with the line conductors (P, N) of said electric line, wherein said detection module includes a magnetic core (3A) for enchaining the line conductors of said electric line and a secondary winding arrangement (3B) coupled to said magnetic core and including a secondary winding (31) wound around said magnetic core, wherein said secondary winding arrangement is adapted to receive in input at least a driving voltage ($V_A$, $V_B$) configured to make said magnetic core to operate in a magnetic saturation condition, wherein said secondary winding arrangement is adapted to provide in output a detection voltage ($V_C$) indicative of a current ($I_W$) flowing along said secondary winding;
    - a comparator module (4) adapted to receive in input said detection voltage ($V_C$) from said secondary winding arrangement (32) and provide in output an interrupt signal (INT), when the current ($I_W$) flowing along said secondary winding has values not included in a predefined range;
- a first driving module (6) adapted to feed said secondary winding arrangement (32) with a first driving voltage ($V_A$) switching between a high voltage level ($V_H$) and a low voltage level ($V_L$) and a second driving module (7) adapted to feed said secondary winding arrangement (32) with a second driving voltage ($V_B$) having a constant voltage level, wherein said first and second driving voltages are configured to make said magnetic core (31) to operate respectively in a positive magnetic saturation condition or in a negative magnetic saturation condition;
- a processing module (5) adapted to command said first driving module (6) to switch said first driving voltage ($V_A$) between said high voltage level ($V_H$) and said low voltage level ($V_L$) in response to receiving an interrupt signal (INT) from said comparator module (4),

wherein said processing module (5) is adapted to provide, based on said first driving voltage ($V_A$), a periodicity signal (PS) to check the presence of fault conditions in said sensing stage (20), said periodicity signal including a sequence of count values, each count value (PS) being calculated as a sum between said measured first time interval ($T_H$) and said measured second time interval ($T_L$).

2. Electronic device, according to claim 1, **characterised in that** said processing module (5) is adapted to process said periodicity signal (PS) according to a test procedure including the following steps:

- comparing said periodicity signal with a first time threshold value (PS 1) and a second time threshold value (PS2) higher than said first time threshold value;
- if said periodicity signal is lower than said first time threshold value (PS1) or higher than said second time threshold value (PS2), determining that fault conditions are present in said sensing stage.

3. Electronic device, according to claim 2, **characterised in that** said test procedure comprises the following steps:

- if said periodicity signal (PS) is lower than said first time threshold value (PS1) determining that said secondary winding (31) is at least partially short-circuited or that a high residual current is present in said electric line (100); or
- if said periodicity signal (PS) is higher than said second time threshold value (PS2) determining that said secondary winding (31) is at least partially interrupted or that one or more components of said sensing stage (20) are not correctly operating.

4. Electronic device, according to one or more of the previous claims, **characterised in that** it comprises one or more pairs of electric contacts (10) electrically connectable with corresponding conductors of said electric line (100) and mutually couplable or decouplable.

5. Electronic device, according to one or more of the previous claims, **characterised in that** said processing module (5) is adapted to provide, based on said first driving voltage ($V_A$), a fault signal (FS) indicative of the presence of a residual current in said electric line.

6. Electronic device, according to claim 5, **characterised in that** said fault signal (FS) includes a sequence of count values, each count value (FS) being calculated as a difference between a measured first time interval ($T_H$), during which said first driving voltage ($V_A$) takes said high voltage level ($V_H$), and a measured second time interval ($T_L$), during which said first driving voltage ($V_A$) takes said low voltage level ($V_L$).

7. Electronic device, according to claim 6, **characterised in that** said processing module (5) is adapted to process said fault signal (FS) to determine whether a tripping manoeuvre or opening manoeuvre is required or to provide an alarm signal (AS) or a monitoring signal (MS) indicative of a detected residual current.

8. Electronic device, according to claim 7, **characterised in that** said processing module (5) is adapted to process said fault signal (FS) according to a determination procedure (50) including the following steps:

- basing on the behaviour of said fault signal (FS), calculating (51) a maximum trip delay value (TD) for said electronic device;
- comparing (52) the module of said fault signal (FS) with a current threshold value (TT);
- if the module of said fault signal (FS) is higher than said current threshold value (TT) for a time interval (T3) longer than said maximum trip delay value (TD), determining (53) that a tripping manoeuvre or opening manoeuvre is required.

9. Electronic device, according to one of the previous claims, **characterised in that** said secondary winding arrangement (3B) comprises a resistive circuit (32) electrically connected in series to said secondary winding (31) to form a RL circuit in cooperation with said secondary winding.

10. Electronic device, according to claim 9, **characterised in that** said secondary winding arrangement (3B) comprises a first input terminal (A) electrically connected in series with said secondary winding (31) and adapted to receive said first driving voltage ($V_A$), a second input terminal (B) electrically connected in series with said resistive circuit (32) and adapted to receive said second driving voltage ($V_B$) and an output terminal (C) electrically connected in series with a coupling node (N) between said secondary winding and said resistive circuit and adapted to provide said detection voltage ($V_C$) indicative of a current flowing along said secondary winding.

11. Electronic device, according to one of the previous claims, **characterised in that** said comparator module (4) is adapted to compare said detection voltage (Vc) with a first voltage threshold value ($V_{TH1}$) and a second voltage threshold value ($V_{TH2}$) higher than said first threshold value, wherein said comparator module is adapted to provide in output said interrupt signal (INT) when said detection voltage (Vc) is lower than said first voltage threshold value ($V_{TH1}$) or when said detection voltage is higher than said second voltage threshold value ($V_{TH2}$).

12. Electronic device, according to one or more of the previous claims, **characterised in that** said sensing stage (20) comprises a timer module (9A) and a clock module (9B) adapted to cooperate with said processing module (5) to carry out time measuring tasks.

13. Electronic device, according to claim 12, **characterised in that** said processing module (5), timer module (9A) and clock module (9B) are adapted to measure said first time interval ($T_H$) and said second time interval ($T_L$) in response to receiving said interrupt signal (INT) by said processing module (5).

14. Electronic device, according to one or more of the previous claims, **characterised in that** said sensing stage (20) comprises a controller (201), wherein at least said comparator module (4), said processing module (5), said first driving module (6) and said second driving module (7) are internal components of said controller.

15. Electronic device, according to claim 14, **characterised in that** said controller (201) is fed by a supply voltage having a voltage level VS given by the following relation:

$$VS <= V_H - V_L$$

wherein $V_H$ is said high voltage level and $V_L$ is said low voltage level.

16. Electronic device, according to one or more of the previous claims, **characterised in that** it comprises a further sensing stage (20A) adapted to sense the presence of fault conditions in said electric line or electronic device regardless of the availability of a power supply voltage (VS) to feed the internal electric or electronic components of said electronic device.

FIG. 1

SC

100A

100

1

100B

LD

FIG. 2

FIG. 2A

FIG. 2B

EP 4 050 349 A1

**FIG. 3**

**FIG. 4**

EP 4 050 349 A1

FIG. 5

FIG. 6

FIG. 7

FIG. 8

**FIG. 9**

FIG. 10

Europäisches
Patentamt

European
Patent Office

Office européen
des brevets

# EUROPEAN SEARCH REPORT

Application Number

EP 21 15 9202

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 726 680 A1 (ABB SCHWEIZ AG [CH]) 21 October 2020 (2020-10-21) * paragraph [0012] - paragraph [0088]; figures 2,3 * ----- | 1-16 | INV. G01R19/20 H02H3/33 |
| A | GB 2 203 907 A (QUALCAST GARDEN PROD) 26 October 1988 (1988-10-26) * the whole document * ----- | 1-16 | |

TECHNICAL FIELDS
SEARCHED      (IPC)

G01R
H02H

The present search report has been drawn up for all claims

| Place of search | Date of completion of the search | Examiner |
|---|---|---|
| Munich | 16 August 2021 | Lindquist, Jim |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

....................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 21 15 9202

This annex lists the patent family members relating to the patent documents cited in the above-mentioned European search report.
The members are as contained in the European Patent Office EDP file on
The European Patent Office is in no way liable for these particulars which are merely given for the purpose of information.

16-08-2021

| Patent document cited in search report | | Publication date | Patent family member(s) | | Publication date |
|---|---|---|---|---|---|
| EP 3726680 | A1 | 21-10-2020 | EP | 3726680 A1 | 21-10-2020 |
| | | | WO | 2020212216 A1 | 22-10-2020 |
| GB 2203907 | A | 26-10-1988 | GB | 2203907 A | 26-10-1988 |
| | | | GB | 2204198 A | 02-11-1988 |

EPO FORM P0459

For more details about this annex : see Official Journal of the European Patent Office, No. 12/82